# EUROPEAN PATENT SPECIFICATION

(11) **EP 0 868 688 B1**
(45) Date of publication and mention of the grant of the patent: **23.02.2000**
(21) Application number: 96942160.1
(22) Date of filing: 11.12.1996
(51) Int. Cl.: G06F 1/24

(54) **A RESET CIRCUIT FOR ENSURING PROPER RESET WHEN USED WITH DECAYING POWER SUPPLIES**
RÜCKSETZSTELLUNGSSCHALTUNG ZUR SICHERSTELLUNG DER KORREKTEN RÜCKSETZSTELLUNG FÜR DEN FALL ZUSAMMENBRECHENDER STROMVERSORGUNG
CIRCUIT DE REINITIALISATION DESTINE A ASSURER UNE REINITIALISATION CORRECTE EN CAS DE BAISSE PROGRESSIVE D'ALIMENTATION ELECTRIQUE

(30) Priority: 22.12.1995 US 609178; 02.01.1996 GB 9600002; 14.11.1996 US 748888
(43) Date of publication of application: 07.10.1998
(73) Proprietor: THOMSON CONSUMER ELECTRONICS, INC., Indianapolis, IN 46290-1024 (US)
(72) Inventor: PITSCH, Robert, Alan, Indianapolis, IN 46236 (US)
(74) Representative: Hartnack, Wolfgang, Dipl.-Ing.
(86) International application number: US9619608
(87) International publication number: WO9723820

(56) References cited:
- EP-A- 0 486 889
- US-A- 5 313 112
- ELECTRONIC ENGINEERING, vol. 62, no. 762, 1 June 1990, page 25/26 XP000128915 BROWNE J ET AL: "COST-EFFECTIVE RESET CIRCUIT"
- EDN ELECTRICAL DESIGN NEWS, vol. 38, no. 11, 27 May 1993, page 144 XP000368479 MATSUNAGA D: "DISCHARGER PREVENTS P LATCHUP"

## Description

The present invention relates to a reset circuit for use in electronic equipment, and in particular, to a reset circuit which operates properly in the presence of a slowly decaying power supply during power off sequencing.

### DESCRIPTION OF THE PRIOR ART

Electronic equipment, such as a microprocessor, operate properly only when the voltage of their operating power supply is greater than a predefined minimum operating voltage. If the power supply voltage should drop below this voltage, the operation of the equipment becomes undefined, and erratic. If, for instance, a microprocessor is allowed to continue running under these conditions, it may perform operations which will damage the system in which the microprocessor is installed.

In order to prevent erratic operation caused by a power supply voltage below the minimum operating voltage, existing reset circuitry monitors the power supply voltage, and generates a reset signal when the power supply voltage drops below a predetermined trigger voltage. This reset signal is supplied to the electronic equipment (i.e. microprocessor), and conditions it to cease operation and enter a quiescent state.

In general, the reset signal is a signal which is at ground potential during the reset period, and at the power supply voltage otherwise. Prior art reset signal generators comprise a voltage sensing network, and a semiconductor switch coupled between the reset signal terminal and ground. This switch is activated during reset periods, thereby coupling the reset signal terminal to ground.

When a power interruption occurs, the voltage sensing network senses that the power supply voltage has dropped below the trigger voltage, and conditions the semiconductor switch to close, thus, generating the reset signal. The reset signal conditions the electronic equipment to enter the quiescent state before the power supply voltage drops below that equipment's minimum operating voltage. This reset signal is ideally maintained until the power supply voltage reaches zero, and further operation of the electronic equipment is impossible.

Normally, when a power interruption occurs, the power supply voltage drops relatively rapidly. Prior art reset circuits operate properly under these conditions. However, it is possible for the voltage of the power supplies to decay relatively slowly during a power interruption due to their design, the filter capacitance, and/or their loading.

Under these conditions, the voltage sensing network and semiconductor switch will generate the reset signal properly at the desired voltage, as above. However, the voltage sensing network may cease to operate reliably as the power supply voltage slowly continues to drop. For example, as the power supply voltage drops slowly, the activation of the semiconductor switch may cause the voltage on the reset capacitor to rebuild, or a charge path to the decaying power supply can condition the voltage sensing network to, erroneously, remove the reset signal. Similarly, when the reset signal is generated, it conditions the electronic system to enter a quiescent state. This, in turn, causes a decrease in the current drawn from the power supply, and, therefore, a slight rise in the power supply voltage.

In either or both of these conditions, the semiconductor switch generating the reset signal may be released before the power supply voltage decays to zero, when all operation of the electronic equipment ceases. The reset signal begins to rise toward VCC and the electronic equipment may leave the quiescent state. This in turn may allow the electronic equipment to enter an unknown state from which it may not start properly at the next reapplication of power, or it may operate erratically causing damage to the system in which it is used.

A reset signal generating circuit which operates properly in the presence of a slowly decaying power supply voltage is desirable.

An example of a known reset circuit is described in EDN Electrical Design News, vol. 38, no. 11, 27 May 1993, XP000368479, page 144, D. Matsunaga, entitled "Discharger Prevents MP Latchup". This reset circuit includes a power supply providing a main power supply voltage (12V) and an operating voltage (5V). A voltage sensing circuit is provided by a voltage comparator having a non-inverting input coupled to receive the 5 volt supply and the inverting input coupled to receive a reference voltage of 4.3 volts provided by a Zener diode powered by the 12 volt supply. The input stage of the comparator generates a control signal internally when the 5 volt supply drops below the Zener voltage. The comparator is of a type including an open-collector output stage which forms a control circuit responsive to the control signal for generating a reset signal. Specifically, the control circuit comprises an open-collector output transistor in the comparator which is coupled via a resistor to a reset output terminal that is coupled to ground via a first capacitor and is coupled to the 5 volt supply via a resistor. The Matsunaga circuit also includes a further capacitor connected in parallel with the Zener diode whereby the Zener reference voltage is maintained at the input of the comparator as the 12 supply decays. In operation, if the 5 volt supply drops below the Zener voltage of 4.3 volts, the open collector output of the comparator clamps the reset terminal to ground.

It is herein recognized that one difficulty with the Matsunaga circuit, is that there is no provision for ensuring that the open collector output transistor of the comparator has sufficient power to maintain conduction throughout the reset interval. This problem may occur since the further capacitor across the Zener diode only maintains the Zener reference voltage at the comparator input whereas the operating power (i.e., base current) for the comparator open-collector output transistor comes from the 12 volt supply and the 12 voltage supply might decay to zero sooner than the 5 volt supply. If that should happen, computer errors may occur due to the reset signal being removed (i.e., turn-off of the output transistor) while the 5 volt supply is still discharging. Also, the circuit requires a relatively expensive voltage comparator having an open collector output (e.g., a type LM339 or LM393) for providing the functions of voltage sensing and output clamping.

Another example of a reset circuit is described by Macks in US patent 5,313,112 entitled LOW VOLTAGE INHIBITING CIRCUIT FOR A MICROCOMPUTER which issued 17 May 1994. The Macks circuit includes a Zener diode voltage sensing circuit which turns a first common emitter stage off when the high voltage (B+) supply voltage drops. Turn off of the first transistor enables turn on of a second common emitter stage by current supplied from the high voltage supply whereupon the second transistor clamps a reset output terminal to ground. Feedback is provided from the reset output terminal to the Zener diode to establish hysteresis between the on and off switching points of the reset circuit. To ensure that there is an initial time delay for the microprocessor internal clock to stabilize, the reset circuit includes a capacitor connected in parallel with the base-emitter junction of the first transistor which forms a time-constant (delay) circuit in combination with the Zener source resistors.

It is herein recognized that, as in the previous example, collapse of the high voltage supply (B+) prior to complete discharge of the regulated supply (Vcc) may result in turn-off of the output transistor since all operating bias (i.e., base current) for this transistor is supplied by the high voltage supply.

A further example of a reset circuit is described by Browne et al. in Electronic Engineering, vol. 62, no. 762, 1 June 1990, XP000128915, pages 25-26, entitled "Cost-effective Reset Circuit". The circuit includes a trigger circuit including a Zener diode connected to a 13 volt supply of a 5 volt regulator. A latch circuit is provided that is powered by the 5 volt regulator and triggered by the Zener diode when the high voltage (13 V) supply decreases below the Zener voltage. The latch circuit comprises a pair of NPN transistors with the collector of each connected to the base of the other with the emitter of one being connected to the 5 volt supply and the emitter of the other being connected to ground via a resistor. When triggered on by the Zener diode, the latch is regenerative thus producing a reset signal at the collector of the first transistor that "tracks" or "follows" the 5 volt supply.

It is herein recognized that, as in the previous examples, a problem exists in the circuit in maintaining the reset signal as the voltage supply collapses. Specifically, when the 5 volt supply drops below the sum of the base-emitter threshold voltages of the two transistors, the latch will no longer be regenerative and will turn off thus removing the reset signal before complete collapse of the 5 volt supply.

### Summary of the Invention

The present invention resides in part in recognizing that the prior art reset circuits discussed above are subject, for the reasons stated, to premature turn off of the reset signal.

It is an object of the present invention to provide a reset circuit which provides a reset signal of sufficient duration that all power supplies can decay to zero.

The principles of the invention have application to reset circuits of a type comprising a power supply (Vss,Vcc) for providing a main power supply voltage (Vss) and for providing an operating voltage (Vcc). A voltage sensing circuit (Z1, R5,R6,T2,R2,D1)_is coupled to the power supply (Vss,Vcc), for generating a control signal when a given one of the voltages provided by the power supply drops below a predetermined voltage. A control circuit (R4,T1,C1,R1) is provided for generating a reset signal in response to the control signal and power providing circuitry (D2,C2,R3) is provided for providing power to a given one of the voltage sensing and control circuits when a selected one of the voltages provided by the power supply drops below a given value.

A reset circuit embodying the invention is characterized in that the voltage sensing circuit generates the control signal when the main power supply voltage (Vss) drops below the predetermined voltage (9.8v); and the power providing circuitry (D2,C2,R3) provides power to the control circuit for maintaining the reset signal when the operating voltage (Vcc) drops below a further predetermined voltage.

### BRIEF DESCRIPTION OF THE DRAWINGS

In the drawing:

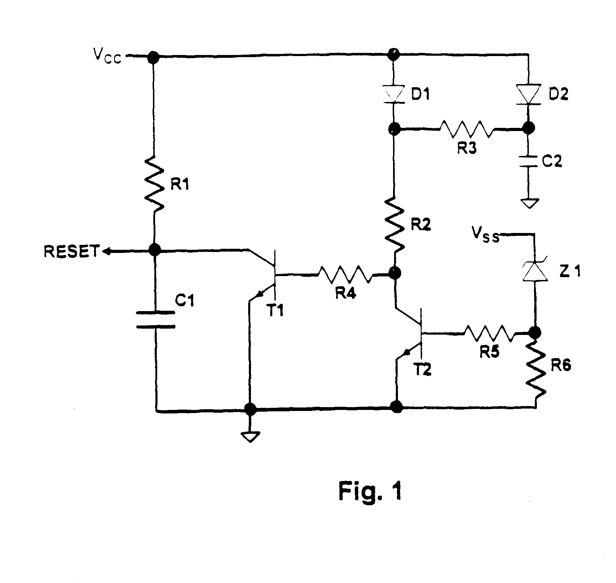

Fig. 1 is a schematic diagram illustrating a reset signal generator according to the present invention.

### End Brief Description of the Drawing Detailed Description

In Fig. 1, a main power supply (not shown) produces a main power supply voltage, VSS. In the illustrated embodiment, the main power supply voltage is 21.2 volts. From the main power supply, an operating voltage, VCC, for electronic equipment (also not shown) in the system, is derived. In the illustrated embodiment, the operating voltage is 5 volts. As is generally the case, so long as the main power supply voltage VSS remains above a trigger voltage (described in more detail below) the operating voltage VCC for the electronic equipment will remain relatively constant.

The source (not shown) of the electronic equipment operating voltage, VCC, is coupled to a first electrode of a first resistor R1, and to respective anodes of a first diode D1 and a second diode D2. A second electrode of the first resistor R1 is coupled to the reset signal output terminal, RESET, a collector electrode of a first NPN transistor T1, and a first electrode of a first capacitor C1. The reset signal output terminal, RESET, is coupled to respective reset signal input terminals of devices in electronic equipment (not shown), which may, for example, include a microprocessor. A second electrode of the capacitor C1 is coupled to a source of a reference potential (ground). The emitter electrode of the first NPN transistor T1 is also coupled to ground.

A cathode of the first diode D1 is coupled to respective first electrodes of a second resistor R2 and a third resistor R3. A second electrode of the second resistor R2 is coupled to a first electrode of a fourth resistor R4 and a collector electrode of a second NPN transistor T2. A second electrode of the fourth resistor R4 is coupled to the base electrode of the first NPN transistor T1. An emitter electrode of the second NPN transistor T2 is coupled to ground. A cathode of the second diode D2 is coupled to a second electrode of the third resistor R3 and a first electrode of a second capacitor C2. A second electrode of the second capacitor C2 is coupled to ground.

The main power supply (not shown), producing the main power supply voltage VSS (from which the electronic equipment operating voltage VCC is derived), is coupled to a cathode of a Zener diode Z1. An anode of the Zener diode Z1 is coupled to respective first electrodes of a fifth resistor R5 and a sixth resistor R6. A second electrode of the fifth resistor R5 is coupled to a base electrode of the second NPN transistor T2. A second electrode of the sixth resistor R6 is coupled to ground.

In the description, below, of the operation of the circuit illustrated in Fig. 1 the various junction voltages of the first and second NPN transistors, T1 and T2, respectively, are ignored, unless explicitly referred to. These transistors are standard NPN transistors, and one skilled in the art will understand what the nominal junction voltages are for the various operating conditions described below, and will be able to compensate for these voltages appropriately during the design of such a circuit.

In operation, the first resistor R1 and the first capacitor C1 cooperate to generate a reset signal at the reset signal output terminal, RESET, on power-up in a known manner. The remainder of the circuit illustrated in Fig. 1 monitors the main power supply VSS and generates a reset signal at the reset signal output terminal, RESET, when the voltage of the main power supply VSS falls lower than a trigger voltage which is higher than the voltage at which the electronic equipment operating voltage, VCC, begins to drop.

Initially both the main power supply (VSS) and the electronic equipment operational power supply (VCC) are at full voltage: e.g. 21.2 volts and 5 volts, respectively. In this condition, the combination of the Zener diode Z1 and the sixth resistor R6 produce a substantially constant voltage drop across the Zener diode Z1 in a known manner. In a preferred embodiment, the Zener diode Z1 is a 9.1 volt zener diode, and the constant voltage drop across the Zener diode Z1, thus, is 9.1 volts. The voltage across the sixth resistor R6, therefore, is 12.1 volts. The second NPN transistor T2, therefore, is on, and the voltage at the junction of the second resistor R2 and the fourth resistor R4 is zero. The first NPN transistor T1, therefore, is off.

The voltage across the capacitor C1 is charged to +5 volts through resistor R1, and the signal at the reset signal output terminal is +5 volts, indicating that the reset signal is not asserted. The first diode D1 is on, and 5 volts is dropped across the second resistor R2. The second capacitor C2 is charged to 5 volts through the second diode D2, which is off. There is no current flowing through the third resistor R3 because the voltage is the same at both of its electrodes. In summary, in the normal operating condition of the circuit illustrated in Fig. 1, the first NPN transistor T1 is off, the second NPN transistor T2 is on, and both capacitors C1 and C2 are charged to 5 volts.

If a power interruption occurs, the main power supply voltage, VSS, begins to drop. As described above, so long as the main power supply voltage VSS is above a known minimum voltage, the electronic equipment operating voltage VCC remains relatively constant. It is assumed the voltages drop relatively slowly in the present example. So long as the voltage on the VSS power supply remains above 9.8 volts (9.1 volts across the Zener diode Z1 plus .7 volt base-emitter junction voltage on the second NPN transistor T2), the circuit remains in the condition described above. When the voltage on the VSS power supply drops to 9.8 volts from 21.2 volts, the Zener diode Z1 turns off, and the voltage at the base electrode of the second NPN transistor T2 is pulled to zero via the fifth and sixth resistors, R5 and R6, respectively. The second NPN transistor T2, thus, turns off. This, in turn, allows the voltage at base electrode of the first NPN transistor T1 to be pulled up via the second, third and fourth resistors, R2, R3 and R4, respectively. The NPN transistor T1, thus, turns on. This connects the reset signal output terminal, RESET, to ground, generating a reset signal.

Thus, the reset signal is generated at the reset signal output terminal, RESET, before the main power supply voltage VSS drops to the voltage at which the electronic equipment power supply voltage, VCC, begins to drop. When the voltage, VCC, at the electronic equipment operational power supply does begin to drop, the second capacitor C2 retains its voltage, and the second diode D2 turns off. The third resistor R3 is relatively large, much larger than the sum of the second and fourth resistors. Thus, the voltage at the junction of the second and third resistors, R2 and R3, respectively, which would be present at that junction due to the voltage divider action on the voltage on the second capacitor C2 is relatively low. So long as the voltage, VCC, at the electronic equipment operational power supply remains above this voltage, the first diode D1 remains on, pulling the voltage at that junction to the voltage, VCC, at the electronic equipment operational power supply. During this time, the first NPN transistor T1 remains on, and the second capacitor C2 discharges slowly through the third resistor R3 toward the current voltage at the VCC power supply, minus the .7 volt diode voltage drop across the first diode D1.

When the voltage, VCC, at the electronic equipment operational power supply drops below the voltage divider voltage (described above) at the junction of the second and third resistors, R2 and R3, respectively, the first diode D1 turns off, isolating the reset circuitry from the decaying electronic equipment operational power supply (VCC). The voltage at the base electrode of the first NPN transistor T1 is pulled up to the voltage on the second capacitor C2 through the second, third and fourth resistors, R2, R3 and R4, respectively. During this time, the second capacitor C2 discharges through the third, second and fourth resistors, R3, R2 and R4, respectively, and the base-emitter junction of the first NPN transistor T1. The current will be relatively low, and the values of the second capacitor C2 and the second, third, and fourth resistors, R2, R3, and R4, respectively, can be selected so that the second capacitor C2 will retain sufficient charge to maintain the first NPN transistor T1 on for a long enough duration that all power supplies can decay to zero, where no further operation of the electronic equipment is possible, regardless of how slow the voltage at the VCC power supply is decaying.

The power supply in the illustrated embodiment provides two voltages, one of which provides power to the electronic equipment and the reset circuit, and the other one of which is monitored. One skilled in the art will understand that this invention may also be used in a system including only a single power supply voltage, which is both monitored and used to provide power to the electronic equipment and the reset circuit. Also, the transistors in the illustrated embodiment are bipolar NPN transistors. One skilled in the art will understand that other types of transistors, such as FETs, etc., may also be used, and will understand how to couple the control electrodes, corresponding to the base electrodes in the illustrated NPN transistors, and the main conduction paths, corresponding to the collector-emitter paths in the illustrated NPN transistors, in the proper manner, to provide the same functions as illustrated in Fig. 1.

A reset circuit as illustrated in Fig. 1 will maintain a reset signal at the reset signal output terminal, RESET, reliably for a time sufficient for all power supplies to decay to zero, regardless of how slowly the power supply voltages decay.

## Claims

1. A reset circuit, comprising:
a power supply (Vss,Vcc) for providing a main power supply voltage (Vss) and for providing an operating voltage (Vcc);
a voltage sensing circuit (Z1, R5,R6,T2,R2,D1) coupled to said power supply (Vss,Vcc), for generating a control signal when a given one of said voltages provided by said power supply drops below a predetermined voltage;
a control circuit (R4,T1,C1,R1) for generating a reset signal in response to the control signal; and
power providing circuitry (D2,C2,R3) for providing power to a given one of said voltage sensing and control circuits when a selected one of said voltages provided by said power supply drops below a given value;
**characterized in that:**
said voltage sensing circuit generates said control signal when said main power supply voltage (Vss) drops below said predetermined voltage (9.8v); and
said power providing circuitry (D2,C2,R3) provides power to said control circuit for maintaining said reset signal when said operating voltage (Vcc) drops below a further predetermined voltage.

2. The system of claim 1 wherein the power providing circuitry (D2,C2,R3)_comprises circuitry for providing power to the control circuit (R4,T1,C1,R1) for as long as it takes the operating voltage to reach zero volts during a power interruption.

3. The system of claim 1 wherein the control circuit (R4,T1,C1) comprises a first transistor (T1) having a control electrode responsive to the control signal, one end (emitter) of a main conductive path coupled to a source of a reference potential (ground), and the other end (collector) of the main conductive path producing the reset signal.

4. The system of claim 3 wherein the control electrode of the transistor (T1) is further coupled to the power providing circuitry (D2,C2,R3).

5. The system of claim 3 wherein the voltage sensing circuitry comprises:
a second transistor (T2) having a main conductive path coupled between the control electrode of the first transistor (T1) and the source of reference potential; and
circuitry (Z1, R6,R5), responsive to the operating voltage (Vcc), for conditioning the second transistor to turn off when the operating voltage drops below the predetermined voltage, and turn on otherwise.

6. The system of claim 5 wherein the second transistor (T2) conditioning circuitry comprises the serial connection of a Zener diode (Z1) and a resistor (R6) coupled between the power supply (Vss) and a source of reference potential (ground).

7. The system of claim 5 wherein the second transistor (T2) comprises a control electrode coupled to the second transistor conditioning circuitry (Z1,R6).

8. The system of claim 5 wherein the power providing circuitry comprises:
a voltage storage device (C2) coupled to the control electrode of the first transistor (T1); and
circuitry (D2), coupled between the power supply (Vcc) and the voltage storage device (C2), for providing operating voltage to the voltage storage device while the operating voltage is above the predetermined voltage.

9. The system of claim 8 wherein the voltage storage device (C2) comprises a capacitor.

10. The system of claim 8 wherein the operating voltage providing circuitry comprises a diode (D2) coupled between the power supply (Vcc) and the voltage storage device (C2).

11. The system of claim 8 wherein the power providing circuitry further comprises a resistor (R3,R2,R4) coupled between the voltage storage device (C2) and the control electrode of the first transistor (T1).

12. The system of claim 1 wherein the voltage sensing circuitry comprises:
a transistor (T2); and
circuitry (Z1, R6,R5) responsive to the operating voltage (Vss), for conditioning the transistor (T2) to turn off when the operating voltage (Vss) drops below the predetermined voltage, and turn on otherwise.

13. The system of claim 12 wherein the transistor conditioning circuitry comprises the serial connection of a Zener diode (Z1) and a resistor (R6) coupled between the power supply (Vss) and a source of reference potential (ground).

14. The system of claim 12 wherein the transistor (T2) comprises a control electrode coupled to the transistor conditioning circuitry, one end of a main conductive path coupled to a source of reference potential (ground), and the other end of the main conductive path producing the control signal.

15. The system of claim 1 wherein the power providing circuitry comprises:
a voltage storage device (C2) coupled to the control circuit; and
circuitry (D2), coupled between the power supply (Vcc) and the voltage storage device, for providing operating voltage to the voltage storage device while the operating voltage is above the predetermined voltage.

16. The system of claim 15 wherein the voltage storage device (C2) comprises a capacitor.

17. The system of claim 15 wherein the circuitry for providing operating voltage to the voltage storage device comprises a diode (D2) coupled between the power supply (Vcc) and the voltage storage device (C2).

## Patentansprüche

1. Rücksetzschaltung, enthaltend:
ein Netzteil (Vss, Vcc) zum Liefern einer Netz-Betriebsspannung (Vss) und zum Liefern einer Arbeitsspannung (Vcc),
eine mit dem Netzteil (Vss, Vcc) verbundene Spannungs-Abtastschaltung (Z1, R5, R6, T2, R2, D1) zum Erzeugen eines Steuersignals, wenn eine der durch das Netzteil gelieferten Spannungen unter eine vorbestimmte Spannung abfällt, eine Steuerschaltung (R4, T1, C1, R1) zum Erzeugen eines Rücksetzsignals aus dem Steuersignal und
eine Betriebsspannungs-Schaltung (D2, C2, R3) zum Liefern von Leistung an eine der Spannungs-Abtast- und Steuerschaltungen, wenn eine ausgewählte Spannung der durch das Netzteil gelieferten Spannungen unter einen bestimmten Wert abfällt,
dadurch gekennzeichnet, daß
die Spannungs-Abtastschaltung das Steuersignal erzeugt, wenn die Netz-Betriebsspannung (Vss) unter die vorbestimmte Spannung (9,8 V) abfällt und die die Leistung liefernde Schaltung (R2, C2, R3) Leistung zu der Steuerschaltung liefert, um das Rücksetzsignal aufrechtzuerhalten, wenn die Arbeitsspannung (Vcc) unter eine weitere vorbestimmte Spannung abfällt.

2. System nach Anspruch 1, wobei die die Leistung liefernde Schaltung (D2, C2, R3) eine Schaltung zum Liefern von Leistung an die Steuerschaltung (R4, T1, C1, R1) für so lange enthält, wie die Arbeitsspannung benötigt, um während einer Stromunterbrechung den Wert von null Volt zu erreichen.

3. System nach Anspruch 1, wobei die Steuerschaltung (R4, T1, C1) einen ersten Transistor (T1) mit einer Steuerelektrode enthält, die auf das Steuersignal anspricht, und ein Ende (Emitter) eines Haupt-Stromwegs mit einer Quelle einer Referenzspannung (Erde) verbunden ist und das andere Ende (Kollektor) des Haupt-Stromwegs das Rücksetzsignal erzeugt.

4. System nach Anspruch 3, wobei die Steuerelektrode des Transistors (T1) außerdem mit der eine Betriebsspannung liefernden Schaltung (D2, C2, R3) verbunden ist.

5. System nach Anspruch 3, wobei die Spannungs-Abtastschaltung folgendes enthält:
einen zweiten Transistor (T2) mit einem Haupt-Stromweg zwischen der Steuerelektrode des ersten Transistors (T1) und der Quelle der Referenzspannung und
eine auf die Arbeitsspannung (Vcc) ansprechende Schaltung (Z1, R6, R5), die den zweiten Transistor abschaltet, wenn die Arbeitsspannung unter die vorbestimmte Spannung abfällt, und ansonsten einschaltet.

6. System nach Anspruch 5, wobei die Schaltung zum Steuern des zweiten Transistors (T2) eine Reihenschaltung einer Zenerdiode (Z1) und eines Widerstands (R6) zwischen dem Netzteil (Vss) und einer Referenzspannungs-Quelle (Erde) enthält.

7. System nach Anspruch 5, wobei der zweite Transistor (T2) eine Steuerelektrode enthält, die mit der den zweiten Transistor steuernden Schaltung (Z1, R6) verbunden ist.

8. System nach Anspruch 5, wobei die die Leistung liefernde Schaltung folgendes enthält:
eine Spannungs-Speichereinheit (C2), die mit der Steuerelektrode des ersten Transistors (T1) verbunden ist, und
eine Schaltung (D2) zwischen dem Netzteil (Vcc) und der Spannungs-Speichereinheit (C2) zum Liefern einer Arbeisspannung an die Spannungs-Speichereinheit, während die Arbeitsspannung oberhalb der vorbestimmten Spannung liegt.

9. System nach Anspruch 8, wobei die Spannungs-Speichereinheit (C2) einen Kondensator enthält.

10. System nach Anspruch 8, wobei die die Arbeitsspannung liefernde Schaltung eine Diode (D2) zwischen dem Netzteil (Vcc) und der Spannungs-Speichereinheit (C2) enthält.

11. System nach Anspruch 8, wobei die die Leistung liefernde Schaltung außerdem einen Widerstand (R3, R2, R4) zwischen der Spannung-Speichereinheit (C2) und der Steuerelektrode des ersten Transistors (T1) enthält.

12. System nach Anspruch 1, wobei die Spannungs-Abtastschaltung folgendes enthält:
einen Transistor (T2) und
eine auf die Arbeitsspannung (Vss) ansprechende Schaltung (Z1, R6, R5), die den Transistor (T2) abschaltet, wenn die Arbeitsspannung (Vss) unter die vorbestimmte Spannung abfällt, und ansonsten einschaltet.

13. System nach Anspruch 12, wobei die den Transistor steuernde Schaltung eine Reihenschaltung einer Zenerdiode (Z1) und eines Widerstands (R6) zwischen dem Netzteil (Vss) und einer Referenzspannungs-Quelle (Erde) enthält.

14. System nach Anspruch 12, wobei der Transistor (T2) eine Steuerelektrode enthält, die mit der den Transistor steuernden Schaltung verbunden ist, und ein Ende eines Haupt-Stromwegs mit einer Referenzspannungsquelle (Erde) verbunden ist und das andere Ende des Haupt-Stromwegs das Steuersignal erzeugt.

15. System nach Anspruch 1, wobei die die Leistung liefernde Schaltung folgendes enthält:
eine mit der Steuerschaltung verbundene Spannungs-Speichereinheit (C2) und
eine Schaltung (D2) zwischen dem Netzteil (Vcc) und der Spannungs-Speichereinheit zum Liefern der Arbeitsspannung zu der Spannungs-Speichereinheit, während die Arbeitsspannung oberhalb der vorbestimmten Spannung liegt.

16. System nach Anspruch 15, wobei die Spannungs-Speichereinheit (C2) einen Kondensator enthält.

17. System nach Anspruch 15, wobei die Schaltung zum Liefern der Arbeitsspannung zu der Spannungs-Speichereinheit eine Diode (D2) zwischen dem Netzteil (Vcc) und der Spannungs-Speicherinheit (C2) enthält.

## Revendications

1. Circuit de réinitialisation comprenant :
une alimentation (Vss, Vcc) pour fournir une tension d'alimentation principale (Vss) et pour fournir une tension de fonctionnement (Vcc);
un circuit détecteur de tension (Z1, R5, R6, T2, R2, D1) couplé à ladite alimentation (Vss, Vcc) pour générer un signal de commande lorsqu'une tension donnée desdites tensions fournies par ladite alimentation chute sous une tension prédéterminée;
un circuit de commande (R4, T1, C1, R1) pour générer un signal de réinitialisation en réponse au signal de commande; et
un circuit d'alimentation (D2, C2, R3) pour alimenter un circuit donné desdits circuits détecteur de tension et de commande lorsqu'une tension sélectionnée desdites tensions fournies par ladite alimentation chute sous une valeur donnée;
caractérisé en ce que :
ledit circuit détecteur de tension génère ledit signal de commande lorsque ladite tension d'alimentation principale (Vss) chute sous ladite tension prédéterminée (9,8 V); et
ledit circuit d'alimentation (D2, C2, R3) alimente ledit circuit de commande pour maintenir ledit signal de réinitialisation lorsque ladite tension de fonctionnement (Vcc) chute sous une autre tension prédéterminée.

2. Système selon la revendication 1, dans lequel le circuit d'alimentation (D2, C2, R3) comprend un circuit pour alimenter le circuit de commande (R4, T1, C1, R1) pour tout le temps nécessaire pour que la tension de fonctionnement atteigne zéro volt, lors d'une coupure de l'alimentation.

3. Système selon la revendication 1, dans lequel le circuit de commande (R4, T1, C1) comprend un premier transistor (T1) ayant une électrode de commande sensible au signal de commande, une extrémité (émetteur) d'un chemin conducteur principal couplée à une source d'un potentiel de référence (masse), et l'autre extrémité (collecteur) du chemin conducteur principal produisant le signal de réinitialisation.

4. Système selon la revendication 3, dans lequel l'électrode de commande du transistor (T1) est en outre couplée au circuit d'alimentation (D2, C2, R3).

5. Système selon la revendication 3, dans lequel le circuit détecteur de tension comprend :
un deuxième transistor (T2) ayant un chemin conducteur principal couplé entre l'électrode de commande du premier transistor (T1) et la source de potentiel de référence; et
un circuit (Z1, R6, R5) sensible à la tension de fonctionnement (Vcc) pour conditionner le deuxième transistor de façon à ce qu'il se bloque lorsque la tension de fonctionnement chute sous la tension prédéterminée, et se débloque dans le cas contraire.

6. Système selon la revendication 5, dans lequel le circuit conditionnant le deuxième transistor (T2) comprend la connexion en série d'une diode Zener (Z1) et d'une résistance (R6) couplées entre l'alimentation (Vss) et une source de potentiel de référence (masse).

7. Système selon la revendication 5, dans lequel le deuxième transistor (T2) comprend une électrode de commande couplée au circuit de conditionnement du deuxième transistor (Z1, RG).

8. Système selon la revendication 5, dans lequel le circuit d'alimentation comprend :
un dispositif de stockage de tension (C2) couplé à l'électrode de commande du premier transistor (T1); et
un circuit (D2), couplé entre l'alimentation (Vcc) et le dispositif de stockage de tension (C2), pour fournir une tension de fonctionnement au dispositif de stockage de tension pendant que la tension de fonctionnement est supérieure à la tension prédéterminée.

9. Système selon la revendication 8, dans lequel le dispositif de stockage de tension (C2) comprend un condensateur.

10. Système selon la revendication 8, dans lequel le circuit fournissant la tension de fonctionnement comprend une diode (D2) couplée entre l'alimentation (Vcc) et le dispositif de stockage de tension (C2).

11. Système selon la revendication 8, dans lequel le circuit d'alimentation comprend en outre une résistance (R3, R2, R4) couplée entre le dispositif de stockage de tension (C2) et l'électrode de commande du premier transistor (T1).

12. Système selon la revendication 1, dans lequel le circuit détecteur de tension comprend :
un transistor (T2); et
un circuit (Z1, R6, R5) sensible à la tension de fonctionnement (Vss) pour conditionner le transistor (T2) de façon à ce qu'il se bloque lorsque la tension de fonctionnement (Vss) chute sous la tension prédéterminée, et se débloque dans le cas contraire.

13. Système selon la revendication 12, dans lequel le circuit conditionnant le transistor comprend la connexion en série d'une diode Zener (Z1) et d'une résistance (R6) couplées entre l'alimentation (Vss) et une source de potentiel de référence (masse).

14. Système selon la revendication 12, dans lequel le transistor (T2) comprend une électrode de commande couplée au circuit conditionnant le transistor, une extrémité d'un chemin conducteur principal couplée à une source d'un potentiel de référence (masse), et l'autre extrémité du chemin conducteur principal produisant le signal de commande.

15. Système selon la revendication 1, dans lequel le circuit d'alimentation comprend :
un dispositif de stockage de tension (C2) couplé au circuit de commande; et
un circuit (D2), couplé entre l'alimentation (Vcc) et le dispositif de stockage de tension (C2), pour fournir une tension de fonctionnement au dispositif de stockage de tension pendant que la tension de fonctionnement est supérieure à la tension prédéterminée.

16. Système selon la revendication 15, dans lequel le dispositif de stockage de tension (C2) comprend un condensateur.

17. Système selon la revendication 15, dans lequel le circuit fournissant la tension de fonctionnement au dispositif de stockage de tension comprend une diode (D2) couplée entre l'alimentation (Vcc) et le dispositif de stockage de tension (C2).
